# EUROPÄISCHE PATENTSCHRIFT

(11) **EP 3 111 734 B1**
(45) Veröffentlichungstag und Bekanntmachung des Hinweises auf die Patenterteilung: **24.01.2018**
(21) Anmeldenummer: 15716392.4
(22) Anmeldetag: 26.02.2015
(51) Int. Cl.: H05K 1/18, H05K 3/10, H01L 23/538

(54) **VERFAHREN ZUM KONTAKTIEREN EINES IN EINE LEITERPLATTE EINGEBETTETEN BAUELEMENTS SOWIE LEITERPLATTE**
METHOD FOR MAKING CONTACT WITH A COMPONENT EMBEDDED IN A PRINTED CIRCUIT BOARD
PROCÉDÉ DE CONNEXION ÉLECTRIQUE D'UN COMPOSANT INCORPORÉ DANS UN CIRCUIT IMPRIMÉ AINSI QUE CIRCUIT IMPRIMÉ

(30) Priorität: 27.02.2014 AT 501522014
(43) Veröffentlichungstag der Anmeldung: 04.01.2017
(73) Patentinhaber: AT & S Austria Technologie & Systemtechnik Aktiengesellschaft, 8700 Leoben (AT)
(72) Erfinder: WEIDINGER, Gerald, A-8700 Leoben (AT); ZLUC, Andreas, A-8700 Leoben (AT); Stahr, Johannes, 8605 St. Lorenzen (AT)
(74) Vertreter: Patentanwaltskanzlei Matschnig & Forsthuber OG
(86) Internationale Anmeldenummer: PCT/AT2015/050052
(87) Internationale Veröffentlichungsnummer: WO 2015/127489

(56) Entgegenhaltungen:
- WO-A1-2013/029074
- DE-A1- 19 642 488
- DE-B3-102010 042 567
- US-A1- 2008 067 666

## Beschreibung

Die Erfindung bezieht sich auf ein Verfahren zum Kontaktieren eines in eine Leiterplatte eingebetteten Bauelements.

Weiters bezieht sich die Erfindung auf eine Leiterplatte mit zumindest einer Isolierschicht und zumindest einer strukturierten Leiterschicht mit Leiterbahnen, mit zumindest einem in die Isolierschicht unter Verwendung einer Kleberschicht in eine Vertiefung der Leiterplatte eingebetteten Bauelement, dessen Anschlüsse im Wesentlichen in der Ebene einer die zumindest eine Leiterschicht aufweisenden Außenfläche der Leiterplatte liegen und mit leitenden Verbindungen zwischen den Anschlüssen des Bauelements und Leiterbahnen der Leiterschicht

Das Einbetten von Bauteilen, wie insbesondere von Halbleiterchips, in Leiterplattenstrukturen ist dem Fachmann geläufig, wobei im Rahmen der Erfindung Strukturen betrachtet werden, bei welchen die Anschlüsse des Bauteils im Wesentlichen in einer Ebene an der Außenfläche der Leiterplatte liegen, wobei man auch von "surface embedded components" spricht. Die elektrischen Anschlüsse des Bauelements müssen mit einer Leiterstruktur kontaktiert werden, wozu verschiedene Wege beschritten wurden.

Beispielsweise zeigt die DE 10 2006 009 723 A1 ein Verfahren zum Einbetten eines Bauelements in eine Leiterplatte und zu dessen Kontakten, bei welchem auf ein metallisches Substrat eine erste Isolierschicht mit einer Leiterstruktur aufgebracht wird. Sodann wird ein Fenster bzw. ein Ausschnitt für den Chip in der ersten Schicht erzeugt und in dieses unter Belassen eines Spaltes ein Chip eingesetzt und mit Hilfe eines Klebstoffes auf dem Substrat fixiert. Die Anschlüsse des Chips befinden sich dabei an einer von dem Substrat abgewandten Kontaktseite. Darüber wird eine photostrukturierte zweite isolierende Schicht aufgetragen, welche die Kontaktstellen des Chips freilässt und dann erfolgt durch galvanisches Abscheiden eines Leitermaterials ein elektrisches Kontaktieren zwischen den Chipanschlüssen und der Leiterstruktur auf der ersten Schicht. Nachteilig an dem bekannten Verfahren bzw. dem erhaltenen Produkt ist die Tatsache, dass im Abstandsbereich zwischen Chip und angrenzenden Lagen ein Hohlraum verbleibt, der beim Aufbau weiterer Lagen zu Delaminationsproblemen führen kann.

WO2013/029074 A1, US2008/067666 A1, DE19642488 A1 und DE 102010042567 B3 offenbaren alternative Verfahren zum Einbetten eines Bauelements in einer Leiterstruktur.

WO2013/029074 A1 offenbart insbesondere ein Verfahren zum Kontaktieren eines in eine Leiterplatte eingebetteten Bauelements, mit den folgenden Schritten: - Bereitstellen eines Cores, das zumindest eine Isolierschicht und zumindest eine auf der Isolierschicht aufgebrachte Leiterschicht aufweist, - Einbetten zumindest eines Bauelements - Freilegen von Stirnflachen der Anschlüsse - Ablagern einer Schicht von Leitermaterial auf den freigelegten Stirnflächen der Anschlüsse und Bilden einer Leiterstruktur zumindest auf der einen Außenfläche des Cores, an der das Bauelement angeordnet ist, sowie der Verbindungsleitungen zwischen den Anschlüssen und der Leiterstruktur.

Eine Aufgabe der Erfindung liegt in der Schaffung eines Verfahrens, mit dessen Hilfe einfach und kostengünstig eine Leiterstruktur in der Ebene der Anschlüsse samt entsprechenden Kontaktierungen erzeugt werden kann, ohne dass die Gefahr des Ablösens von Schichten besteht.

Diese Aufgabe wird mit einem Verfahren der eingangs genannten Art gelöst, welches erfindungsgemäß die folgenden Schritte aufweist:
a) Bereitstellen eines Cores, das zumindest eine Isolierschicht und zumindest eine auf der Isolierschicht aufgebrachte Leiterschicht aufweist,
b) Einbetten zumindest eines Bauelements in eine Vertiefung der Isolierschicht, wobei die Anschlüsse des Bauelements im Wesentlichen in der Ebene einer die zumindest eine Leiterschicht aufweisenden Außenfläche der Leiterplatte liegen,
c) Aufbringen eines photostrukturierbaren Lacks auf die eine Außenfläche des Cores, an der das Bauelement angeordnet ist, unter Ausfüllen der Räume zwischen den Anschlüssen des Bauelements,
d) Freilegen von Stirnflächen der Anschlüsse und der von dem photostrukturierbaren Lack bedeckten Gebiete der Leiterschicht durch Belichten und Entwickeln des photostrukturierbaren Lacks,
e) durch Anwenden eines semi-additiven Prozesses Ablagern von Leitermaterial auf den freigelegten Stirnflächen der Anschlüsse sowie den freigelegten Gebieten der Leiterschicht und Bilden einer Leiterstruktur zumindest auf der einen Außenfläche des Cores, an der das Bauelement angeordnet ist, sowie der Verbindungsleitungen zwischen den Anschlüssen und der Leiterstruktur und
f) Entfernen der nicht zur Leiterstruktur gehörenden Bereiche der Leiterschicht.

Dank der Erfindung kann die "Verdrahtung" von eingebetteten Bauteilen auf derselben Lage bzw. Ebene wie die Einbettung erfolgen, sodass die Leiterplatten dünner ausgebildet werden können und die oben genannten Probleme der Gefahr eines Ablösens ergeben sich nicht.

Dabei ist es empfehlenswert, wenn das Entfernen der Bereiche der Leiterschicht in Schritt f) durch Flash-Etching erfolgt.

In Hinblick auf die zusätzliche Funktion des photostrukturierbaren Lacks als Bestandteil der fertigen Leiterplatte ist es vorteilhaft, wenn der in Schritt c) verwendete photostrukturierbare Lack ein Epoxid basierter Lack ist.

Bei einer besonders günstigen Variante des erfindungsgemäßen Verfahrens kann vorgesehen sein, dass in Schritt b) das Bauelement unter Verwendung einer Kleberschicht in eine Vertiefung des Cores eingebettet wird, wobei die Kleberschicht sämtliche Flächen des Bauelements, ausgenommen jene mit den Anschlüssen, vollständig umgibt und im Wesentlichen bis zur Ebene der Oberfläche der Leiterplatte reicht, in welcher die Stirnflächen der Anschlüsse liegen.

Besonders zweckmäßig reicht dabei die Vertiefung des Cores durch die Leiterschicht hindurch in die Isolierschicht.

Die gestellten Aufgaben werden auch mit einer Leiterplatte der oben angegebenen Art gelöst, bei welcher erfindungsgemäß die Oberflächen der Verbindungen und der Leiterbahnen der Leiterschicht in einer Ebene liegen, die Kleberschicht sämtliche Flächen des Bauelements, ausgenommen jene mit den Anschlüssen, vollständig umgibt, die Räume zwischen den Anschlüssen des Bauelements mit einem ausgehärteten, photostrukturierbaren Lack gefüllt sind und auf den Stirnflächen der Anschlüsse sowie auf einer Leiterschicht der Leiterplatte im Bereich der Leiterbahnen eine zusätzliche Leiterschicht aufgebracht ist.

Bei einer bevorzugten Ausführungsform ist vorgesehen, dass der ausgehärtete, photostrukturierbare Lack die freien Stirnflächen der Kleberschicht zwischen der Außenwandung des Bauelements und der Innenwandung der Vertiefung der Leiterplatte bedeckt.

In einer Weiterbildung der Erfindung umfasst die Leiterplatte weiterhin ein Core, das zumindest eine Isolierschicht und zumindest eine auf der Isolierschicht aufgebrachte Leiterschicht aufweist, wobei eine mit zumindest einer Leiterschicht versehene Außenfläche des Cores eine Vertiefung aufweist, welche durch die Leiterschicht hindurch in die Isolierschicht reicht, wobei das Bauelement unter Verwendung einer Kleberschicht in der Vertiefung des Cores eingebettet ist und wobei die Anschlüsse des Bauelements im Wesentlichen in der Ebene der die zumindest eine Leiterschicht sowie die Vertiefung aufweisenden Außenfläche des Cores liegen.

Die Erfindung samt weiteren Vorteilen ist im Folgenden an Hand einer beispielsweisen Ausführungsform des Verfahrens bzw. der Leiterplatte näher beschrieben, was in der Zeichnung veranschaulicht ist. In dieser zeigen
Fig. 1 in einem Schnitt durch einen Teilabschnitt ein in den ersten Schritten des Verfahrens hergestelltes Core mit einer eingebetteten Komponente,
Fig. 2 den Aufbau der Fig. 1 nach Aufbringen eines photostrukturierbaren Lacks,
Fig. 3 den Aufbau nach Belichten und Entwickeln des photostrukturierbaren Lacks,
Fig. 4 den Aufbau nach Ablagern von weiteren Leitermaterial durch Anwenden eines semi-additiven Prozesses und
Fig. 5 den Aufbau der fertigen Leiterplatte nach Wegätzen eines Teils der leitenden Beläge.

Unter Bezugnahme auf die Figuren werden nun das Verfahren nach der Erfindung sowie eine erfindungsgemäße Leiterplatte erläutert. Dabei ist unter dem im Folgenden verwendeten Begriff "Core" im Rahmen der gegenständlichen Beschreibung ein ausgehärtetes Prepreg mit einer Leiterschicht (Kupferlage) an zumindest einer Oberfläche zu verstehen.

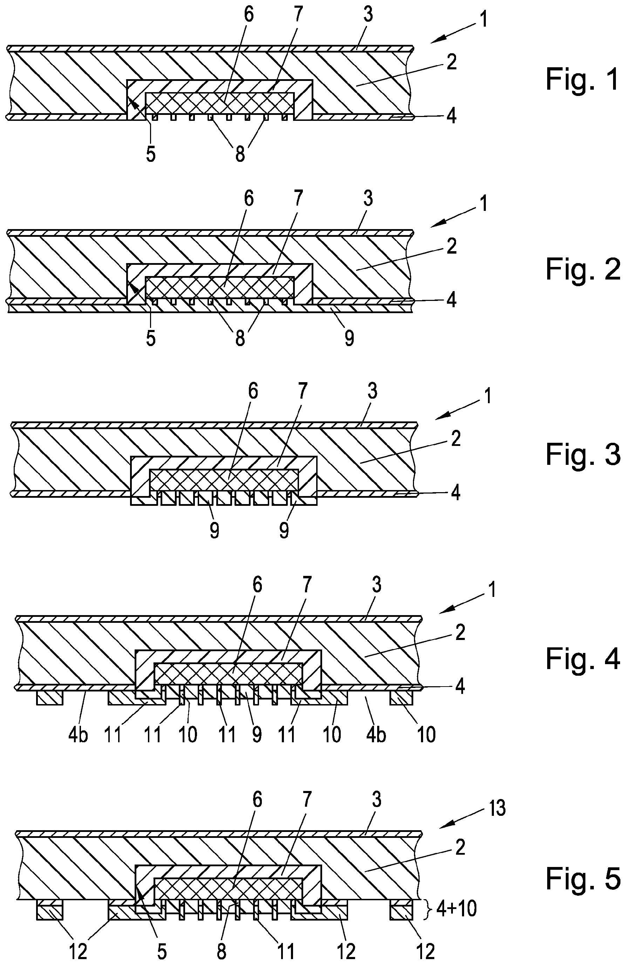

**Fig. 1** zeigt einen Teil eines Cores 1, das aus einer Isolierschicht 2, beispielsweise bestehend aus einem in der Leiterplattenindustrie allgemein verwendeten Prepreg-Material, wie FR 4, und einer oberen Leiterschicht 3 sowie einer unteren Leiterschicht 4. An dieser Stelle sei angemerkt, dass sich die Begriffe "oben" und "unten" nur auf die Darstellungen in den Zeichnungen beziehen und zur Erleichterung der Beschreibung verwendet werden. Beispielsweise Schichtdicken sind 100 µm für die Isolierschicht 2 und 1 bis 5 µm, typisch 2 µm, für die obere bzw. untere Leiterschicht 3 bzw. 4.

In dem Core 1 wird eine Vertiefung 5 ausgebildet, in welche ein Bauelement 6 unter Verwendung einer Kleberschicht 7 eingebettet wird, wobei die Schichtdicke dieser Kleberschicht beispielsweise 20 bis 200 µm beträgt. Das Bauelement 6, z.B. ein Halbleiter-Chip, trägt an einer Außenfläche Anschlüsse 8, z.B. Kupferpads, wobei die Kleberschicht 7 sämtliche Flächen des Bauelements 6, ausgenommen jene mit den Anschlüssen 8, vollständig umgibt und im Wesentlichen bis zur Ebene der Oberfläche des Cores 1 reicht, in welcher die Stirnflächen der Anschlüsse 8 liegen, somit hier der unteren Fläche. Als Kleber kommt beispielsweise ein lösungsmittelfreier bzw. lösungsmittelarmer Epoxidharzkleber mit einem Glaserweichungspunkt typisch von 120° bis 150°C in Frage, der in die Vertiefung 5 gedruckt, eingefüllt oder eingespritzt wird. Nach der Bestückung mit dem Bauelement 6 wird dieser Kleber bei Temperaturen von 110° bis 150°C gehärtet.

In einem nächsten Schritt wird zumindest auf die Außenfläche des Cores 1 mit den Stirnflächen der Anschlüsse 8 ein Epoxid-basierter photostrukturierbarer Lack 9 aufgebracht, wobei auf **Fig. 2** Bezug genommen wird. Beispielsweise für diesen Zweck geeignete Produkte bzw. Materialien sind der Lack XB7081 mit dem Namen Probelec® der Fa. Huntsman oder der aus der lithographischen Galvanikabformung (LIGA) bekannte Fotolack SU-8 der Firma Microchem Corp. Wie man erkennt, füllt der Lack 9 sämtliche Räume zwischen den Anschlüssen 8 des Bauelements 6 aus und erstreckt sich auch über die untere Leiterschicht 4.

Sodann kann mit einem in der Leiterplattenherstellung üblichen fotolithographischen Prozess ein Strukturieren vorgenommen werden, wobei zunächst das Belichten mit einer Filmmaskierung oder durch LDI (Laser Direct Imaging) erfolgt. In der Folge wird entwickelt, nach Wegwaschen mit geeigneten Chemikalien die Strukturierung erhalten und das Material vollständig ausgehärtet. Das Härten erfolgt mit Hilfe üblicher Härtungsmethoden, wie z.B. thermisches Härten, UV- oder IR-Härten, Anwendung von Laserstrahlung etc. Das Strukturieren bzw. Belichten erfolgt in der Weise, dass die Anschlüsse 8, genauer gesagt deren Stirnflächen, freigelegt werden, wozu auf **Fig. 3** verwiesen wird. Dieser Strukturierungsvorgang wird so ausgeführt, dass der ausgehärtete, photostrukturierbare Lack 9 die freien Stirnflächen der Kleberschicht 7 zwischen der Außenwandung des Bauelements 6 und der Innenwandung der Vertiefung 5 des Core1 bedeckt und die untere Leiterschicht 4 wieder freigelegt wird.

Nach diesem Belichten und Entwickeln wird ein semi-additiver Prozess zum Auftragen von Leitermaterial, i.A. Kupfer, entsprechend der gewünschten Struktur vorgenommen. Dabei wird in den gewünschten Bereichen, insbesondere für Leiterzüge, eine Schicht 10 aus Leitermaterial aufgebracht, welche auch unter Bildung von Verbindungsleitungen 11 von den Stirnflächen der Anschlüsse 8 ausgehend zu der gewünschten Leiterstruktur abgelagert wird. Andererseits wird im Bereich der gewünschten Leiterzüge bzw. Leiterstruktur die untere Leiterschicht 4 verstärkt. Dieses Ergebnis ist in **Fig. 4** ersichtlich.

Da zwischen den Verdickungen der unteren Leiterschicht 4 durch die Schicht 10, welche die Leiterzüge bilden sollen, noch Brücken 4b bestehen, erfolgt in einem weiteren Schritt das Entfernen dieser Brücken 4b und anderen unerwünschten Leitermaterials. Die erfolgt vorzugsweise durch sogenanntes "Flash-Etching", worunter man das Abätzen der Basiskupferfolie und einen geringen Abtrag der galvanisch aufgebrachten Kupferschichten versteht. Dieser Ätzvorgang erfolgt beispielsweise mit einem sauren Medium, z.B. HCl unter Zugabe H₂O₂ und von Stabilisatoren, wobei die kleinen Kristallite der Basisfolie deutlich schneller aufgelöst werden als die galvanisch abgeschiedenen Schichten und eine selektive Ätzung erreicht wird. Nach diesem Vorgang des Abtragens bzw. Ätzens sind auch die Flächen bzw. Räume zwischen den Anschlüssen 9 gereinigt und die endgültigen Leiterbahnen 12 sind freigestellt und fertig gebildet, wozu auf **Fig. 5** verwiesen wird, welche die fertige Leiterplatte 13 mit dem eingebetteten und ankontaktierten Bauelement 6 zeigt.

Bei dem gezeigten Beispiel ist lediglich die Strukturierung der unteren Leiterschicht 4 beschrieben, doch sollte es klar sein, dass auch die obere Leiterschicht 3 in gleicher Weise strukturiert sein kann. Auch ist es möglich, Vias (leitende Durchkontaktierungen) zwischen den beiden Leiterschichten zu bilden, ebenso wie weitere Isolier- und Leiterschichten aufgebaut werden können.

Es sollte schließlich klar sein, dass die Darstellungen der Figuren 1 bis 5 im Allgemeinen nur Ausschnitte aus einer größeren Leiterplattenstruktur zeigen, und in der Praxis auf einer Leiterplatte mehrere Bauelemente an unterschiedlichen Stellen eingebettet und mit Leiterstrukturen verbunden sein können.

## Patentansprüche

1. Verfahren zum Kontaktieren eines in eine Leiterplatte (13) eingebetteten Bauelements (6), mit den folgenden Schritten
a) Bereitstellen eines Cores (1), das zumindest eine Isolierschicht (2) und zumindest eine auf der Isolierschicht (2) aufgebrachte Leiterschicht (3, 4) aufweist,
b) Einbetten zumindest eines Bauelements (6) in eine Vertiefung (5) der Isolierschicht (2), wobei die Anschlüsse (8) des Bauelements (6) im Wesentlichen in der Ebene einer die zumindest eine Leiterschicht (4) aufweisenden Außenfläche des Cores (1) liegen,
c) Aufbringen eines photostrukturierbaren Lacks (9) auf die eine Außenfläche des Cores (1), an der das Bauelement (6) angeordnet ist, unter Ausfüllen der Räume zwischen den Anschlüssen (8) des Bauelements (6),
d) Freilegen von Stirnflächen der Anschlüsse (8) und der von dem photostrukturierbaren Lack (9) bedeckten Gebiete der Leiterschicht (4) durch Belichten und Entwickeln des photostrukturierbaren Lacks (9),
e) durch Anwenden eines semi-additiven Prozesses Ablagern einer Schicht (10) von Leitermaterial auf den freigelegten Stirnflächen der Anschlüsse (8) sowie den freigelegten Gebieten der Leiterschicht (4) und Bilden einer Leiterstruktur (12-12) zumindest auf der einen Außenfläche des Cores (1), an der das Bauelement (6) angeordnet ist, sowie der Verbindungsleitungen (11) zwischen den Anschlüssen (8) und der Leiterstruktur (12-12) und
f) Entfernen der nicht zur Leiterstruktur (12-12) gehörenden Bereiche der Leiterschicht (4+10).

2. Verfahren nach Anspruch 1, **dadurch gekennzeichnet, dass** das Entfernen der Bereiche der Leiterschicht (4+10) in Schritt f) durch Flash-Etching erfolgt.

3. Verfahren nach Anspruch 1 oder 2, **dadurch gekennzeichnet, dass** der in Schritt c) verwendete photostrukturierbare Lack (9) ein Epoxid basierter Lack ist.

4. Verfahren nach einem der Ansprüche 1 bis 3, **dadurch gekennzeichnet, dass** in Schritt b) das Bauelement (6) unter Verwendung einer Kleberschicht (7) in eine Vertiefung (5) des Cores (1) eingebettet wird, wobei die Kleberschicht (7) sämtliche Flächen des Bauelements (6), ausgenommen jene mit den Anschlüssen (8), vollständig umgibt und im Wesentlichen bis zur Ebene der Oberfläche der Leiterplatte (13) reicht, in welcher die Stirnflächen der Anschlüsse liegen.

5. Verfahren nach Anspruch 4, **dadurch gekennzeichnet, dass** die Vertiefung (5) des Cores (1) durch die Leiterschicht (4) hindurch in die Isolierschicht (2) reicht.

6. Leiterplatte (13) mit zumindest einer Isolierschicht (2) und zumindest einer strukturierten Leiterschicht (4+10) mit Leiterbahnen (12), mit zumindest einem in die Isolierschicht (2) unter Verwendung einer Kleberschicht (7) in eine Vertiefung (5) der Leiterplatte (13) eingebetteten Bauelement (6), dessen Anschlüsse (8) im Wesentlichen in der Ebene einer die zumindest eine Leiterschicht (4) sowie die Vertiefung (5) aufweisenden Außenfläche der Leiterplatte (13) liegen und mit leitenden Verbindungen (11) zwischen den Anschlüssen (8) des Bauelements (6) und Leiterbahnen (12) der strukturierten Leiterschicht (4+10), wobei die Oberflächen der leitenden Verbindungen (11) und der Leiterbahnen (12) der strukturierten Leiterschicht (4+10) in einer Ebene liegen,
die Kleberschicht (7) sämtliche Flächen des Bauelements (6), ausgenommen jene mit den Anschlüssen (8), vollständig umgibt,
die Räume zwischen den Anschlüssen (8) des Bauelements (6) mit einem ausgehärteten, photostrukturierbaren Lack (9) gefüllt sind und
auf den Stirnflächen der Anschlüsse (8) sowie auf einer Leiterschicht (4) der Leiterplatte (13) im Bereich der Leiterbahnen (12) eine zusätzliche Leiterschicht (10) aufgebracht ist.

7. Leiterplatte (13) nach Anspruch 6, **dadurch gekennzeichnet, dass** der ausgehärtete, photostrukturierbare Lack (9) die freien Stirnflächen der Kleberschicht (7) zwischen der Außenwandung des Bauelements (6) und der Innenwandung der Vertiefung (5) bedeckt.

8. Leiterplatte (13) nach Anspruch 6 oder 7, weiterhin umfassend ein Core (1), das zumindest eine Isolierschicht (2) und zumindest eine auf der Isolierschicht (2) aufgebrachte Leiterschicht (3, 4) aufweist, wobei eine mit zumindest einer Leiterschicht (4) versehene Außenfläche des Cores (1) eine Vertiefung (5) aufweist, welche durch die Leiterschicht (4) hindurch in die Isolierschicht (2) reicht, **dadurch gekennzeichnet, dass** das Bauelement (6) unter Verwendung einer Kleberschicht (7) in der Vertiefung (5) des Cores (1) eingebettet ist, wobei die Anschlüsse (8) des Bauelements (6) im Wesentlichen in der Ebene der die zumindest eine Leiterschicht (4) sowie die Vertiefung (5) aufweisenden Außenfläche des Cores (1) liegen.

## Claims

1. A method for contacting a component (6) embedded in a printed circuit board (13), said method having the following steps:
a) providing a core (1), which has at least one insulation layer (2) and at least one conductor layer (3, 4) applied to the insulation layer (2),
b) embedding at least one component (6) in an indentation (5) of the insulation layer (2), wherein the terminals (8) of the component (6) lie substantially in the plane of an outer surface of the core (1) having at least one conductor layer (4),
c) applying a photostructurable coating (9) to the outer surface of the core (1) on which the component (6) is arranged, filling the spaces between the terminals (8) of the component (6),
d) exposing end faces of the terminals (8) and the areas of the conductor layer (4) covered by the photostructurable coating (9) by exposing and developing the photostructurable coating (9),
e) by applying a semi-additive process, depositing a layer (10) of conductor material on the exposed end faces of the terminals (8) and on the exposed areas of the conductor layer (4) and forming a conductor structure (12-12) at least on the outer surface of the core (1) on which the component (6) is arranged, and on the connection lines (11) between the terminals (8) and the conductor structure (12-12), and
f) removing the areas of the conductor layer (4+10) not belonging to the conductor structure (12-12).

2. The method according to claim 1, **characterised in that** the areas of the conductor layer (4+10) are removed in step f) by flash etching.

3. The method according to claim 1 or 2, **characterised in that** the photostructurable coating (9) used in step c) is an epoxide-based coating.

4. The method according to any one of claims 1 to 3, **characterised in that** in step b) the component (6) is embedded in an indentation (5) of the core (1) with use of an adhesive layer (7), wherein the adhesive layer (7) fully surrounds all surfaces of the component (6), apart from those with the terminals (8), and reaches substantially as far as the plane of the surface of the printed circuit board (13) in which the end faces of the terminals lie.

5. The method according to claim 4, **characterised in that** the indentation (5) of the core (1) passes through the conductor layer (4) and into the insulation layer (2).

6. A printed circuit board (13) having at least one insulation layer (2) and at least one structured conductor layer (4+10) with conductor tracks (12), having at least one component (6) embedded in the insulation layer (2) with use of an adhesive layer (7) in an indentation (5) of the printed circuit board (13), the terminals (8) of said component lying substantially in the plane of an outer surface of the printed circuit board (13) comprising the at least one conductor layer (4) and the indentation (5), and having conductive connections (11) between the terminals (8) of the component (6) and conductive tracks (12) of the structured conductor layer (4+10),
wherein
the surfaces of the conductive connections (11) and the conductor tracks (12) of the structured conductor layer (4+10) lie in a plane,
the adhesive layer (7) fully surrounds all surfaces of the component (6), apart from those with the terminals (8),
the spaces between the terminals (8) of the component (6) are filled with a cured, photostructurable coating (9), and
an additional conductor layer (10) is applied to the end faces of the terminals (8) and to a conductor layer (4) of the printed circuit board (13) in the region of the conductor tracks (12).

7. The printed circuit board (13) according to claim 6, **characterised in that** the cured photostructurable coating (9) covers the free end faces of the adhesive layer (7) between the outer wall of the component (6) and the inner wall of the indentation (5).

8. The printed circuit board according to claim 6 or 7, further comprising a core (1), which comprises at least one insulation layer (2) and at least one conductor layer (3, 4) applied to the insulation layer (2), wherein an outer surface of the core (1) provided with at least one conductor layer (4) has an indentation (5), which passes through the conductor layer (4) and into the insulation layer (2), **characterised in that** the component (6) is embedded in the indentation (5) of the core (1) with use of an adhesive layer (7), wherein the terminals (8) of the component (6) lie substantially in the plane of the outer surface of the core (1) comprising the at least one conductor layer (4) and the indentation (5).

## Revendications

1. Procédé de connexion électrique d'un composant (6) incorporé dans une carte à circuits imprimés (13), comportant les étapes suivantes :
a) préparation d'une âme (1) qui présente au moins une couche isolante (2) et au moins une couche conductrice (3, 4) déposée sur la couche isolante (2) ;
b) incorporation d'au moins un composant (6) dans un creux (5) de la couche isolante (2), les connexions (8) du composant (6) se trouvant sensiblement dans le plan d'une surface extérieure de l'âme (1) présentant ladite au moins une couche conductrice (4) ;
c) dépôt d'un vernis photostructurable (9) sur la surface extérieure de l'âme (1) sur laquelle le composant (6) est disposé, en remplissant les espaces entre les connexions (8) du composant (6) ;
d) dégagement des faces frontales des connexions (8) et des zones de la couche conductrice (4) recouvertes par le vernis photostructurable (9) par insolement et développement du vernis photostructurable (9) ;
e) au moyen d'une technique semi-additive, dépôt d'une couche (10) de matériau conducteur sur les faces frontales dégagées des connexions (8) ainsi que sur les zones dégagées de la couche conductrice (4) et formation d'une structure conductrice (12-12) au moins sur la surface extérieure de l'âme (1) sur laquelle le composant (6) est disposé, ainsi que des pistes de liaison (11) entre les connexions (8) et la structure conductrice (12-12) ; et
f) élimination des zones de la couche conductrice (4+10) qui n'appartiennent pas à la structure conductrice (12-12) .

2. Procédé selon la revendication 1, **caractérisé par le fait que** l'élimination des zones de la couche conductrice (4+10) à l'étape f) a lieu par gravure flash.

3. Procédé selon l'une des revendications 1 ou 2, **caractérisé par le fait que** le vernis photostructurable (9) utilisé à l'étape c) est un vernis à base époxyde.

4. Procédé selon l'une des revendications 1 à 3, **caractérisé par le fait qu'à** l'étape b), le composant (6) est incorporé à l'aide d'une couche adhésive (7) dans un creux (5) de l'âme (1), la couche adhésive (7) enfermant totalement toutes les surfaces du composant (6), à l'exception de celles avec les connexions (8) et s'étendant sensiblement jusqu'au plan de la surface de la carte à circuits imprimés (13) dans laquelle les faces frontales des connexions se situent.

5. Procédé selon la revendication 4, **caractérisé par le fait que** le creux (5) de l'âme (1) s'étend à travers la couche conductrice (4) dans la couche isolante (2).

6. Carte à circuits imprimés (13) avec au moins une couche isolante (2) et au moins une couche conductrice structurée (4+10) avec des pistes conductrices (12), avec au moins un composant (6) incorporé dans la couche isolante (2) à l'aide d'une couche adhésive (7) dans un creux (5) de la carte à circuits imprimés (13), dont les connexions (8) se trouvent sensiblement dans le plan d'une surface extérieure de la carte à circuits imprimés (13) présentant ladite au moins une couche conductrice (4) ainsi que le creux (5) et avec des liaisons conductrices (11) entre les connexions (8) du composant (6) et des pistes conductrices (12) de la couche conductrice structurée (4+10),
dans laquelle
les surfaces des liaisons conductrices (11) et des pistes conductrices (12) de la couche conductrice structurée (4+10) se situent dans un plan ;
la couche adhésive (7) enferme totalement toutes les surfaces du composant (6), à l'exception de celles avec les connexions (8) ;
les espaces entre les connexions (8) du composant (6) sont remplis par un vernis photostructurable (9), durci ; et
une couche conductrice (10) supplémentaire est déposée sur les faces frontales des connexions (8) ainsi que sur une couche conductrice (4) de la carte à circuits imprimés (13) dans la zone des pistes conductrices (12).

7. Carte à circuits imprimés (13) selon la revendication 6, **caractérisée par le fait que** le vernis photostructurable (9), durci, recouvre les faces frontales libres de la couche adhésive (7) entre la paroi extérieure du composant (6) et la paroi intérieure du creux (5).

8. Carte à circuits imprimés (13) selon l'une des revendications 6 ou 7, comprenant en outre une âme (1), qui présente au moins une couche isolante (2) et au moins une couche conductrice (3, 4) déposée sur la couche isolante (2), une surface extérieure de l'âme (1) dotée d'au moins une couche conductrice (4) présentant un creux (5) qui s'étend à travers la couche conductrice (4) dans la couche isolante (2), **caractérisée par le fait que** le composant (6), à l'aide d'une couche adhésive (7), est incorporé dans le creux (5) de l'âme (1), les connexions (8) du composant (6) se trouvant sensiblement dans le plan de la surface extérieure de l'âme (1) présentant ladite au moins une couche conductrice (4) ainsi que le creux (5).
